# EUROPÄISCHE PATENTSCHRIFT

(11) **EP 4 336 201 B1**
(45) Veröffentlichungstag und Bekanntmachung des Hinweises auf die Patenterteilung: **29.01.2025**
(21) Anmeldenummer: 22194621.3
(22) Anmeldetag: 08.09.2022
(51) Int. Cl.: G01R 31/60, G01R 31/69

(54) **VEREINFACHTER PRÜFAUFBAU BEI DER KABELBAUMPRÜFUNG**
SIMPLIFIED TEST SETUP IN CABLE HARNESS TESTING
MONTAGE DE TEST SIMPLIFIÉ POUR LE TEST DE FAISCEAUX DE CÂBLES

(43) Veröffentlichungstag der Anmeldung: 13.03.2024
(73) Patentinhaber: ESPI Logistics GmbH, 91126 Schwabach (DE)
(72) Erfinder: Lochmann, Rüdiger, 91126 Schwabach (DE)
(74) Vertreter: Kanzlei Dr. Negendanck Patentmanufaktur

(56) Entgegenhaltungen:
- DE-A1- 102011 087 152
- DE-A1- 102016 109 741
- DE-A1- 102016 116 695
- DE-B3- 102019 133 227

## Beschreibung

Die Erfindung betrifft die Prüfung eines Kabelbaums mit Hilfe eines Prüfsystems.

Ein Kabelbaum ist z.B. aus "Wikipedia: 'Kabelbaum' ", Wikipedia, Internetseite, https:// de. wikipedia. org/ wiki/ Kabelbaum, Abruf am 05.09.2022 bekannt: Die Prüfung der elektrischen Funktion eines Kabelbaums kann mit Hilfe eines Prüftisches durchgeführt werden. Der Prüftisch wird dazu vorher mit den Daten des Schaltplans programmiert.

Derartige Prüftische bzw. Prüfsysteme sind z.B. aus "TSK: 'Prüftische' ", Fa. TSK, Internetseite, https:// www. t-s-k. de/ kabelpruefsysteme/ prueftische/, Abruf am 05.09.2022 bekannt: Ein komplettes Prüfsystem für den Verbindungstest (elektrischer Test) von Kabelsätzen (Kabelbäumen) besteht aus Prüfmodulen, Testpunktkarten, Kabeltester, PC, Prüfsoftware und Prüftisch.

Dokument DE 10 2019 133 227 B3 offenbart ein Prüfsystem zum Prüfen einer Leitungsanordnung. Das Prüfsystem umfasst einen Prüftisch mit einer Schaltmatrix; eine Rechnersteuerung, welche dazu konfiguriert ist, die Schaltmatrix des Prüftisches zu steuern; ein Prüfmodul und eine Messvorrichtung zu Messen einer elektrische Eigenschaft. Das Prüfmodul umfasst ein Steuerungsmodul zum Steuern wenigstens einer Funktion des Prüfmoduls. Das Steuerungsmodul ist über eine vollständig außerhalb der Schaltmatrix verlaufende Steuerverbindung mit der Rechnersteuerung kommunikationstechnisch verbindbar. Zudem verfügt das Prüfsystem über eine Lokalisierungsfunktion, mit welcher die Position des Prüfmoduls auf dem Prüftisch bestimmt werden kann. Hierzu wird an Kontakten des Prüfmoduls ein Lokalisierungsmuster bereitgestellt, welches von der Rechnersteuerung unter Verwendung der Schaltmatrix und der Messvorrichtung identifiziert werden kann.

Aufgabe der vorliegenden Erfindung ist es, Verbesserungen in Bezug auf die Prüfung eines Kabelbaums mithilfe eines Prüfsystems zu realisieren.

Die Aufgabe wird gelöst durch eine Prüfanordnung gemäß Patentanspruch 1. Bevorzugte oder vorteilhafte Ausführungsformen der Erfindung sowie anderer Erfindungskategorien ergeben sich aus den weiteren Ansprüchen, der nachfolgenden Beschreibung sowie den beigefügten Figuren.

Die Prüfanordnung ist eine solche für ein Prüfsystem bzw. Bestandteil eines Prüfsystems. Das Prüfsystem dient zum Prüfen eines Kabelbaumes. Der Kabelbaum weist eine Mehrzahl von Leitungen auf.

Die Prüfanordnung enthält eine Sammelleitung. Die Sammelleitung ist an einer Zentraleinheit des Prüfsystems anschließbar bzw. im Betrieb angeschlossen. Der Anschluss erfolgt z.B. über eine an der Sammelleitung vorhandenen Schnittstelle. Die Schnittstelle ist zum Beispiel ein einfacher Leitungsanschluss der Sammelleitung oder auch eine sogenannte Steuerungskarte. Diese führt ggf. auch Anpassungen von Signalen, Umsetzung von Busprotokollen oder ähnliches zwischen Sammelleitung und Zentraleinheit durch.

Insbesondere ist an der Sammelleitung also eine Steuerungskarte angeschlossen. Die Zentraleinheit ist dann an die Sammelleitung über die Steuerungskarte anschließbar. Die Steuerungskarte ist dabei z.B. zu einer Signalumsetzung hinsichtlich Sammelleitung und Zentraleinheit eingerichtet. In der Steuerungskarte findet z.B. eine Umsetzung eines Signalprotokolls statt. Beispielsweise werden Nichtbusbasierte Signale auf der Sammelleitung in busbasierte Signale auf einer Datenleitung von der Steuerungskarte zur Zentraleinheit umgesetzt. Die Sammelleitung kann also eine herkömmliche, nicht bus-basierte Leitung / Leitungsbündel sein, z.B. in Form von einem oder mehreren Flachbandkabeln, Stromversorgungsleitungen usw. Alternativ kann auch die Sammelleitung als Bus ausgeführt sein, zum Beispiel als CAN-Bus. In der Steuerungskarte findet dann z.B. eine Signalumsetzung auf einen Ethernet-Bus statt, welcher von der Steuerungskarte zur Zentraleinheit führt.

Die Zentraleinheit ist insbesondere ein übergeordneter PC für die Prüfanordnung. Prüfanordnung und Zentraleinheit zusammen bilden insbesondere das oben genannte Prüfsystem.

Die Prüfanordnung enthält eine Mehrzahl von Prüfeinheiten, die hier auch als logische / symbolische Einheiten zu verstehen sind (ggf. gemeinsame Nutzung der Sammeltestpunktkarten / Anschlussmodule, siehe unten). Jede der Prüfeinheiten enthält genau ein Anschlussmodul und genau ein Prüfmodul. Das Prüfmodul ist dabei an dem Anschlussmodul (zumindest mittelbar über weitere Komponenten) angeschlossen. Jedes der Anschlussmodule ist an der Sammelleitung angeschlossen bzw. anschließbar und bewerkstelligt die Kommunikation / Signalweiterleitung usw. zwischen dem Prüfmodul und der Sammelleitung. Mit anderen Worten ist also ein jeweiliges Prüfmodul nach Art einer Reihenschaltung über genau ein Anschlussmodul an der Sammelleitung angeschlossen.

Obschon also jede der Prüfeinheiten genau ein Anschlussmodul aufweist, kann ein und das selbe Anschlussmodul mehreren Prüfeinheiten zu geordnet bzw. diesen gemeinsam sein. Dies gilt insbesondere für den Fall, dass die Sammeltestpunktkarte das Anschlussmodul enthält oder ist, siehe unten.

### Jedes Prüfmodul ist wie folgt aufgebaut:

Es weist eine bestimmte Anzahl, hier "Steckerpinanzahl" von jeweils einpoligen elektrischen Steckerkontakten (Steckerpins / Steckerpinkontakte) bzw. Anschlusskontakten auf. Ein solcher Steckerkontakt ist zum Beispiel ein Steckerpin, eine Kontaktnadel oder ein Klemmanschluss. An dem Steckerkontakt sind zum Zweck der Prüfung des Kabelbaumes dessen Leitungen elektrisch kontaktiert. Insbesondere ist dabei jeweils genau eine Leitung pro Steckerkontakt kontaktiert, was den Normalfall darstellt. In seltenen Fällen kann dies auch anders sein, z.B. auch ein sogenannter Doppelanschlag gegeben sein, d.h. zwei Leitungen sind auf einen Steckerkontakt geführt. Der Wortteil "Stecker" ist hier also weit bzw. allgemein zu verstehen und lediglich der Deutlichkeit halber gewählt, da Kabelbäume in der Regel mit Hilfe von Steckern an einem Prüfsystem angeschlossen werden. Ein tatsächlicher Stecker am Kabelbaum / Steckeraufnahme am Prüfmodul muss jedoch nicht unbedingt vorhanden sein. Es kann eine beliebige elektrische Kontaktierung des Kabelbaumes stattfinden, z.B. auch über offene Leitungsenden oder CrimpKontakte an Leitungen.

In der Prüfanordnung ist genau eine zu testende Leitung des Kabelbaumes in der Regel zwischen genau zwei Steckerkontakten unterschiedlicher Prüfmodule angeschlossen. Dies ist jedoch nicht zwingend notwendig, gegebenenfalls kann auch nur ein Ende der Leitung an einem Steckerkontakt angeschlossen sein und das zweite Ende nicht, zum Beispiel, wenn dort eine induktive oder kapazitive Erfassung elektrischer Größen stattfindet.

Jeder der Steckerkontakte ist elektrisch auf das Anschlussmodul zu führen, um letztendlich (zumindest informationstechnisch) mit der Sammelleitung in Kontakt zu kommen. Dabei können jedoch auch mehre Steckerkontakte auf einer zumindest teilweise gemeinsamen Leitung dorthin geführt sein, wie weiter unten erläutert wird.

Jedes der Prüfmodule enthält außerdem eine bestimmte Anzahl ("Hilfspinanzahl") von elektrischen Hilfskontakten. Die Hilfskontakte dienen zum Anschluss / zur Verbindung mit einer elektrischen Infrastruktur des Prüfmoduls. Auch die Hilfskontakte sind jeweils elektrisch (ggf. auch über gemeinsame Leitungen, sinngemäß wie die Steckerkontakte oben) auf das Anschlussmodul zu führen.

Um den vorliegenden Text lesbarer zu gestalten wird von "Hilfs-" -anzahl, -leitung, - kontakt usw. gesprochen. Sinngemäß sind dies jedoch Ausdrücke, die mit der Infrastruktur der Prüfmodule zusammenhängen. Insofern müssten klarer von "Infrastruktur-" -anzahl, -leitung, -kontakt usw. gesprochen werden.

Die Infrastruktur eines entsprechenden Prüfmoduls umfasst beispielsweise Anzeigen oder Sensoren, wie z.B. LEDs oder Mikroschalter. Die Hilfskontakte dienen dazu, die entsprechenden Anzeigen / Sensoren usw. elektrisch zu kontaktieren. Insbesondere enthält die Infrastruktur wenigstens eines der Prüfmodule eine arretierbare und elektrisch lösbare Haltevorrichtung für den Kabelbaum, insbesondere einen Stecker / Leitungen dessen. Die Haltevorrichtung bzw. wenigstens das Lösen der Haltevorrichtung / Freigabe des Steckers / der Leitungen ist über wenigstens einen der Hilfskontakte ansteuerbar. So kann der Kabelbaum am Prüfmodul nach Ende der Prüfung elektromechanisch freigegeben werden. Die Arretierbarkeit erfolgt insbesondere ebenfalls elektrisch, alternativ auch auf sonstige Weise, zum Beispiel durch händisches Arretieren. Die Haltevorrichtung dient also zum Beispiel dazu, Leitungen / Stecker des Kabelbaumes mechanisch fest bzw. sicher an den Steckerkontakten zu halten, zum Beispiel einen Stecker des Kabelbaumes in einer entsprechenden Aufnahme am Prüfmodul zu arretieren.

Anstelle der elektrischen Haltevorrichtung kann diese jedoch auch pneumatisch betrieben sein. Ein Lösen von Leitungen aus dem Prüfmodul, z.B. Auswerfen eines Steckers erfolgt dann über einen Pneumatikantrieb. Das Prüfsystem wird hierdurch von dieser Aufgabe entlastet.

Wenigstens eine der Prüfeinheiten enthält einen, insbesondere genau einen, Steckerpinverdichter und / oder einen, insbesondere genau einen, Hilfspinverdichter. Insbesondere enthalten die Prüfeinheiten entweder keinen Verdichter oder nur einen Hilfspinverdichter oder einen Hilfspinverdichter und einen Steckerpinverdichter. Insbesondere enthalten die Prüfeinheiten entweder einen Hilfspinverdichter oder einen Hilfspinverdichter und einen Steckerpinverdichter. Weiter unten genannte Ausführungsformen für Steckerpinverdichter / Hilfspinverdichter bzw. Erläuterungen hierzu gelten stets für den Fall, dass eine Prüfanordnung tatsächlich eine entsprechenden Steckerpinverdichter und / oder einen entsprechenden Hilfspinverdichter enthält.

Für den Fall, dass die Prüfanordnung einen Steckerpinverdichter enthält sind die Steckerkontakte vom Prüfmodul über Steckerpinleitungen zum Steckerpinverdichter geführt. Die Anzahl der Steckerpinleitungen ist hierbei die Steckerpinanzahl. Mit anderen Worten wird jeder der Steckerkontakte über genau eine der Steckerpinleitungen zum Steckerpinverdichter geführt. Vom Steckerpinverdichter führt jedoch nur eine Anzahl keiner der Steckerpinanzahl, nämlich eine "Steckerpinsammelanzahl", von Steckerpinsammelleitungen zum Anschlussmodul.

Die Steckerpinsammelanzahl ist hierbei also um wenigstens "eins" kleiner der Steckerpinanzahl. Die entsprechende Reduzierung der Anzahl von Steckerpinsammelleitungen in Bezug auf die Steckerpinleitungen wird dadurch erreicht, dass im Steckerpinverdichter wenigstens zwei der Steckerpinleitungen eindeutig kodiert auf eine der Steckerpinsammelleitungen geführt sind. Die entsprechende Steckerpinsammelleitung ist also den zwei oder mehr Steckerpinleitungen gemeinsam zugeordnet. Durch die eindeutige Kodierung lässt sich im Prüfsystem jedoch eindeutig rekonstruieren, welche der Steckerpinleitungen zum Beispiel welche elektrischen Signale in die Steckerpinsammelleitung geführt hat usw.

Sinngemäß entsprechend zu oben gilt für den Fall, dass die Prüfanordnung einen Hilfspinverdichter enthält: Die Hilfskontakte sind über die Hilfspinanzahl von Hilfsleitungen ("eins zu eins") zum Hilfspinverdichter geführt. Eine "Hilfspinsammelanzahl" von Hilfspinsammelleitungen führt dann vom Hilfspinverdichter zum Anschlussmodul. Auch hier ist die Hilfspinsammelanzahl wieder um mindestens "eins" kleiner als die Hilfspinanzahl. Auch hier sind im Hilfspinverdichter wenigstens zwei der Hilfsleitungen eindeutig kodiert auf eine Hilfspinsammelleitung geführt. Auch diese Hilfspinsammelleitung ist dann wieder den wenigstens zwei Hilfsleitungen gemeinsam, welche auf diese Hilfspinsammelleitung geführt sind.

Ansonsten, also für den Fall, dass die Prüfanordnung keinen Steckerpinverdichter enthält, ist in der entsprechenden Prüfeinheit die Steckerpinanzahl von Steckerpinleitungen (direkt oder über die Zwischenschaltung von Verarbeitungsstufen, aber dennoch jede einzeln) vom Prüfmodul zum Anschlussmodul geführt. Die Steckerpinanzahl der Leitungen ist also nicht reduziert.

Sinngemäß gilt dies auch für den nicht vorhandenen Hilfspinverdichter: Ansonsten, sollte die Prüfanordnung also keinen Hilfspinverdichter enthalten, ist die Hilfspinanzahl von Hilfsleitungen (direkt oder über die Zwischenschaltung von Verarbeitungsstufen) vom Prüfmodul zum Anschlussmodul geführt.

Insbesondere sind genau ein Steckerpinverdichter und / oder genau ein Hilfspinverdichter pro Prüfeinheit vorgesehen.

Gemäß der Erfindung findet also wenigstens eine "Verdichtung" von Steckerpinleitungen und/oder Hilfsleitungen statt. Wenigstens eine der Hilfsleitungen und / oder wenigstens eine der Steckerpinleitungen ist also im Verlauf zwischen dem betreffenden Verdichter und dem Anschlussmodul eingespart. Hierdurch wird Verkabelung in der Prüfanordnung eingespart, was zu einem reduzierten Verkabelungsaufwand in einer entsprechenden Prüfanordnung / Prüfsystem, also bei der Prüfung eines Kabelbaumes führt.

Durch den reduzierten Verkabelungsaufwand bei der Kabelbaumprüfung wird die Prüfanordnung bzw. das Prüfsystem bzw. dessen Aufbau kostengünstiger. Insbesondere wird es dadurch wirtschaftlich sinnvoll möglich, eine Kabelbaumprüfung bereits während der Fertigung des Kabelbaumes durchzuführen. Ein entsprechender Kabelbaum wird dabei insbesondere auf einem Montagetisch aufgebaut. Die Prüfanordnung lässt sich dann kostentechnisch akzeptabel in den Montagetisch integrieren bzw. an diesem anbringen. Mit anderen Worten kann dank der Erfindung eine Durchführung der Kabelbaumprüfung "online" in einer Montagelinie gelingen. Es ergibt sich also eine WHC Anwendung (wire harness check) in der Montagelinie. Gemäß der Erfindung ergibt sich ein einfacher Systemaufbau, ein reduzierter bzw. minimaler Verdrahtungsumfang sowie eine gute Erweiterbarkeit eines Prüfsystems. Insgesamt ergibt sich wegen der Reduzierung zu verlegender / zu nutzender Kabel ein vereinfachter Prüfaufbau bei der Kabelbaumprüfung. Eine elektromagnetische Entriegelung der Leitungen, insbesondere von Steckern, am Ende einer Prüfung wird dank der elektrisch lösbaren Haltevorrichtung vereinfacht. So wird insbesondere eine aufwändige Pneumatik-Lösung vermieden.

Gemäß der Erfindung erfolgt also geeignete Zusammenschaltung von Hilfsleitungen in Bezug auf die Infrastruktur eines Prüfmoduls und/oder von Steckerpinleitungen in Bezug auf die Steckerkontakte, um hierdurch eine Testpunktreduzierung im Prüfsystem bzw. an der Sammelleitung zu erreichen.

Durch die Reduktion / Verdichtung der Anzahl von notwendigen Leitungen / Kabeln, können (siehe unten) an den Stellen, an denen nur noch wenige Leitungen nötig sind, Standard-Kabel, z.B. Ethernet-Kabel zur Verbindung von Komponenten verwendet, werden. Auch dies spart Aufwand und Kosten ein. Insbesondere können so (siehe unten) Testpunktverdichterkarten mit Sammeltestpunktkarten verbunden werden.

In einer bevorzugten Ausführungsform enthält wenigstens eine der Prüfeinheiten genau eine aktive Testpunktkarte. Diese Testpunktkarte enthält dabei das Anschlussmodul der Prüfeinheit. Das Anschlussmodul befindet sich also nur in der Testpunktkarte und an keinem anderen Ort der Prüfeinheit. Eine derartige Prüfeinheit ist besonders einfach aufgebaut und kann flexibel ausgestaltet werden. Insbesondere lassen sich so einfach auch "passive" Prüfeinheiten (nur Ableitung von Messströmen / -spannungen aus dem Kabelbaum) aufbauen, die auch einen Steckerpinverdichter enthalten können.

In einer bevorzugten Variante dieser Ausführungsform ist die Steckerpinanzahl von Steckerpinleitungen dann vom Prüfmodul zum Anschlussmodul (also nach innerhalb der Testpunktkarte) geführt. Ein Steckerverdichter ist also nicht enthalten. Eine derartige Ausführungsform eignet sich insbesondere für die aktive Einspeisung von Testsignalen in den Kabelbaum und/oder für vergleichsweise große Prüfmodule mit einer vergleichsweise großen Steckerpinanzahl von zum Beispiel mehr als acht oder zwölf Steckerkontakten. Eine Verdichtung findet hierbei - wenn überhaupt - insbesondere nur innerhalb der aktiven Testpunktkarte statt. "Aktiv" ist dabei so zu verstehen, dass die Testpunktkarte Logikschaltungen, aktive Bauteile, zum Beispiel einen Busanschluss, insbesondere die fachübliche "Steuerungsintelligenz" für die Prüfbeschaltung der Steckerkontakte (Einspeisung in den Kabelbaum) enthält. Eine vollständige fachübliche Beschaltung der Steckerpinanzahl von Steckerkontakten am Prüfmodul durch die aktive Testpunktkarte ist möglich: Denn die jeweiligen Steckerpinanzahl von einzelnen Steckerpinleitungen ist komplett durchgängig, also in Form einer Eins-zu-eins-Beschaltung zwischen dem Anschlussmodul und dem Prüfmodul vorhanden. Entsprechende Prüfeinheiten sind also zwar aufwendig und vergleichsweise teuer, jedoch für eine vollständige Kabelbaumprüfung, insbesondere Einspeisung von Prüfsignalen, in fachüblicher Weise geeignet.

In einer bevorzugten Variante dieser Ausführungsform enthält die Prüfeinheit einen, insbesondere genau einen, der Hilfspinverdichter. Der Hilfspinverdichter ist insbesondere ausschließlich in der aktiven Testpunktkarte enthalten. Die Prüfeinheit enthält wie erläutert keinen Steckerpinverdichter. Es gelten daher die obigen Ausführungen zum Hilfspinverdichter: Infolgedessen sind zwischen dem Hilfspinverdichter und dem Anschlussmodul weniger Hilfspinsammelleitungen als Hilfsleitungen zwischen Prüfmodul und Hilfspinverdichter vorhanden. Hier findet wieder eine entsprechende Einsparung von Verkabelung und damit Kosten und Aufwand, jedoch ausschließlich bezüglich der Hilfskontakte, statt. Da bei bestimmten Prüfsystemen die Infrastruktur eines Prüfmoduls genau so wie die Steckerpins über einheitliche "Testpunkte" des Prüfsystems versorgt bzw. beschaltet wird, werden hierdurch auch solche Testpunkte in Bezug auf die Infrastruktur eingespart. Denn es sind weniger Testpunkte nötig, um die gleiche Infrastruktur mit gleicher Funktionalität anzusteuern. Auch dies führt bereits zu einem Vorteil gegenüber herkömmlichen (insbesondere "aktiven") Prüfeinheiten ohne Hilfspinverdichter.

In einer bevorzugten Ausführungsform enthält wenigstens eine der Prüfeinheiten genau eine passive Testpunktverdichterkarte und genau eine Sammeltestpunktkarte. Ausschließlich die Sammeltestpunktkarte enthält dabei das Anschlussmodul oder ist das Anschlussmodul. Sämtliche Komponenten sind wieder signaltechnisch in Reihenschaltung angeordnet, also in der Reihenfolge Prüfmodul - passive Testpunktkarte - aktive Sammeltestpunktkarte (ggf.: - darin enthaltenes Anschlussmodul). Die Steckerpinanzahl von Steckerpinleitungen und die Hilfspinanzahl von Hilfsleitungen ist vom Prüfmodul zur passiven Testpunktverdichterkarte geführt. Ein entsprechender Aufbau eignet sich insbesondere für vergleichsweise kleine Prüfmodule mit einer vergleichsweise kleinen Steckerpinanzahl von zum Beispiel maximal acht Steckerkontakten. Eine Verdichtung ist an verschiedenen Stellen in der Prüfeinheit, beginnend bei der Testpunktverdichterkarte und endend an der Sammeltestpunktkarte bzw. am Anschlussmodul, möglich. "Passiv" ist hierbei so zu verstehen, dass die Testpunktverdichterkarte keinen Busanschluss aufweist, nicht busbasiert arbeitet, keinerlei Logik oder "Intelligenz" hinsichtlich der Testbeschaltung des Kabelbaums enthält. Insbesondere ist die passive Testpunktkarte lediglich aus passiven Bauteilen, insbesondere ausschließlich Widerständen und Dioden, gegebenenfalls auch Kapazitäten / Induktivitäten aufgebaut. Die entsprechende Testpunktverdichterkarte benötigt insbesondere also keinerlei Versorgungsspannung für die Bewerkstelligung der ihr zugedachten Aufgaben, nämlich der (ggf. kodierten / kodierenden) Durchleitung von Signalen / Größen der Steckerkontakte und Hilfskontakte vom Prüfmodul zum Anschlussmodul oder umgekehrt.

In einer bevorzugten Variante dieser Ausführungsform enthält die Prüfeinheit einen, insbesondere genau einen, der Hilfspinverdichter und / oder einen, insbesondere genau einen, der Steckerpinverdichter. Insbesondere sind diese ausschließlich in der passiven Testpunktverdichterkarte angeordnet. Somit sind zwischen passiver Testpunktverdichterkarte und Sammeltestpunktkarte Steckerpinleitungen und / oder Hilfsleitungen eingespart bzw. die entsprechende Steckerpinanzahl und Hilfspinanzahl von Leitungen auf die Steckerpinsammelanzahl bzw. Hilfspinsammelanzahl reduziert. Hierdurch kann eine erhebliche Einsparung von Verkabelungsaufwand und Kosten erreicht werden. Durch den Steckerpinverdichter werden ebenfalls einige der oben erläuterten "Testpunkte" des Prüfsystems eingespart, hier nicht in Bezug auf den Anschluss / die Ansteuerung von Infrastruktur, sondern in Bezug auf eine reduzierte Anzahl von Testpunkten zur Beschaltung von Steckerkontakten / Steckerpins.

In einer bevorzugten Variante dieser Ausführungsform weisen wenigstens zwei der Prüfeinheiten die selbe Sammeltestpunktkarte gemeinsam auf. Mit anderen Worten teilen sich zwei oder mehr der Prüfeinheiten eine einzige selbe Sammeltestpunktkarte bzw. nutzen diese gemeinsam. Hierdurch ist ein erhebliches Einsparungspotenzial für Aufwand und Kosten der Prüfanordnung gegeben.

Dies gilt insbesondere deshalb, da die Sammeltestpunktkarte die einzige "aktive" Einheit in derartigen Prüfeinheiten ist, also nur dort aufwändige und teure "Intelligenz" des Prüfsystems, also aktive / Logik-Bauteile notwendig sind. Die Gruppe von Prüfeinheiten, welche sich die Sammeltestpunktkarte teilt, kann also besonders unaufwändig und kostengünstig realisiert werden. Beispielsweise sind pro Sammeltestpunktkarte bis zu sechzehn Prüfeinheiten möglich, d.h. sechzehn passive Testpunktverdichterkarten mit je einem Prüfmodul (also sechzehn Prüfmodule) sind an einer einzigen gemeinsamen aktiven Sammeltestpunktkarte anschließbar.

In einer bevorzugten Variante dieser Ausführungsform ist wenigstens eine, insbesondere alle, der passiven Testpunktverdichterkarten nicht zur Beschaltung der Steckerkontakte nach einem Prüfschema des Prüfsystems eingerichtet. Diese weisen hierzu insbesondere keine wie oben erläuterte Logik / Intelligenz, also keine Steuer- und Auswerteeinheit oder dergleichen, zur Realisierung fachüblicher Prüfbeschaltung in den entsprechenden Prüfeinheiten auf. Entsprechende Logik / Intelligenz ist also nur in den aktiven Testpunktkarten und ggf. auch in den aktiven Sammeltestpunktkarten enthalten.

In einer bevorzugten Kombination der oben genannten Ausführungsformen ist in der Prüfanordnung nach einem Optimierungsverfahren die Anzahl der Prüfeinheiten mit aktiven Testpunktkarten für die Prüfung eines bestimmten und vorgebbaren Kabelbaums minimiert. Mit anderen Worten wird ein bestimmter Kabelbaum als fehlerfrei bekannt hinsichtlich dessen Aufbau und elektrischer Eigenschaften vorausgesetzt. Dann wird ein Testregime für diesen bestimmt und dann eine Prüfanordnung für diesen Kabelbaum bestimmt. Dies erfolgt so, dass eine möglichst kleine Anzahl von Prüfeinheiten mit aktiven Testpunktkarten eingesetzt ist. Die restliche Beschaltung bzw. Anschluss des Kabelbaumes erfolgt dann über Prüfeinheiten mit passiven Testpunktkarten und (möglichst viel gemeinsam genutzten) Sammeltestpunktkarten. Somit ergibt sich ein besonders kostengünstiger und unaufwändiger Aufbau einer Prüfanordnung und so ein reduzierter Invest: Erreicht durch umfangreichen Einsatz von einfachen kostengünstigen Prüfeinheiten mit Prüfmodul, Testpunktverdichterkarte und Sammeltestpunktkarte und Einsatz von möglichst wenigen Prüfeinheiten mit Prüfmodul und aktiver Testpunktkarte.

Diese Ausführungsform beruht auf der Beobachtung aus der Praxis, dass bei Kabelbäumen in der Regel 80 % der Kabelbaumstecker acht Pins oder weniger aufweisen und somit durch kostengünstige "kleine" Prüfmodule kontaktierbar sind. Weiterhin wurde festgestellt, dass in der Regel die Hälfte der Verkabelung zwischen Sammelleitung und Prüfmodul auf die Verbindung der Steckerkontakte, jedoch die andere Hälfte auf die Verbindung von Hilfskontakten entfällt.

Weiterhin nutzt die Erfindung die Erkenntnis aus der Praxis, dass jedes Leitungsende eines Kabelbaumes über Prüfmodule an die Sammelleitung angeschlossen werden muss. Dabei muss jede der Leitungen des Kabelbaums nur an einer ("ersten") Seite von einem Prüfmodul mit "Intelligenz" (Prüfeinheiten mit "aktiven" Komponenten, hier also den aktiven Testpunktkarten) versorgt werden. Die anderen "zweiten" Leitungsenden können mit passiven / "dummen" Prüfmodulen (Prüfeinheiten mit "passiven" Komponenten, hier also Testpunktverdichterkarten) versorgt werden.

Aus alledem folgt die Erkenntnis, dass eine entsprechende Verdichtung bei den Hilfskontakten daher für alle Prüfmodule / Prüfeinheiten sinnvoll ist, eine Verdichtung von Steckerkontakten jedenfalls bei den Prüfmodulen, die jeweils am "zweiten" Leitungsende einer zu testen Leitung angeschlossen sind. Denn nur das " erste" Leitungsende ist gemäß einem Prüfschema zu beschalten, wozu Logik / Intelligenz im Prüfsystem notwendig ist.

Insofern nutzt die Erfindung die Idee, möglichst viele (idealerweise für alle zweiten Leitungsenden) "dumme" kostengünstig Prüfeinheiten mit passiven Testpunktverdichterkarten an den zweiten Leitungsenden zu nutzen, die über eine entsprechende Intelligenz nicht verfügen müssen. Gemäß dem Optimierungsverfahren erfolgt dann eine jeweils möglichst optimale Verteilung der Anschlüsse (optimal: ausschließlich nur alle ersten Leitungsenden) des Kabelbaumes auf aufwändige Prüfeinheiten (aktive Testpunktkarte), der Rest wird über einfache Prüfeinheiten (passive Testpunktverdichterkarte) abgedeckt. Idealerweise wären also alle ersten Leitungsenden an aufwendigen Prüfeinheiten mit aktiven Testpunktkarten und die restlichen zweiten Leitungsenden an einfachen kostengünstigen Prüfeinheiten mit Testpunktverdichterkarten angeschlossen.

In einer bevorzugten Ausführungsform ist wenigstens eine, insbesondere alle, der

Prüfeinheiten auf der signaltechnisch der Sammelleitung abgewandten Seite des Anschlussmoduls ohne Datenbus ausgeführt. Insbesondere gilt dies ausschließlich für eine oder alle der Prüfeinheiten ohne Steckerverdichter. Insbesondere gilt dies ausschließlich für eine oder alle der Prüfeinheiten mit Testpunktverdichterkarte und Sammeltestpunktkarte. Insbesondere ist dabei die Sammelleitung selbst jedoch als ein Datenbus ausgeführt. Der Datenbus ist insbesondere ein CAN-Bus. Die jeweils restliche (ohne Anschlussmodul) Prüfeinheit kann so Bus-frei und daher besonders einfach, insbesondere rein passiv, ausgeführt werden.

In einer bevorzugten Ausführungsform ist am Steckerpinverdichter die eindeutige Kodierung der Steckerpinleitungen wie folgt bewerkstelligt: wenigstens zwei der Steckerpinleitungen sind über je ein Kennbauteil auf eine gemeinsame Steckerpinsammelleitung zusammengeführt. Die Kennbauteile weisen paarweise verschiedene elektrische Kenngrößen. Diese sind dabei so gewählt, dass die elektrischen Kenngrößen der Kennbauteile aus einem elektrischen Signal rekonstruierbar sind, welches über die gemeinsame Steckerpinsammelleitung fließt. Das Kennbauteil ist zum Beispiel ein Widerstand. Die Widerstände weisen dann als Kenngrößen unterschiedliche Widerstandswerte bzw. paarweise verschiedene Widerstandswerte auf, z.B. 100, 200, 300 ... 1600 Ohm für sechzehn Steckerpinleitungen. Aus der Stromstärke in der Steckerpinsammelleitung kann dann auf den Widerstandswert als Kenngröße und damit auf die aktuell bestromte Steckerpinleitung geschlossen werden, insbesondere, wenn gemäß einem Prüfregime des Prüfsystems sichergestellt ist, dass immer nur eine Steckerpinleitung bestromt ist.

Die Kennbauteile können hierbei im Steckerpinverdichter selbst oder auch außerhalb des Steckerpinverdichters in Richtung zum Kabelbaum hin angeordnet sein, zum Beispiel in den Steckerpinleitungen und / oder im Prüfmodul. Insbesondere sind die Kennbauteile jedoch im Steckerpinverdichter angeordnet. Ein entsprechender Steckerpinverdichter kann passiv und damit besonders einfach und kostengünstig aufgebaut werden.

In einer bevorzugten Ausführungsform ist am Hilfspinverdichter die eindeutige Kodierung der Hilfsleitungen wie folgt bewerkstelligt: Zwischen zwei der Hilfspinsammelleitungen ist - in Richtung zum Kabelbaum hin - eine Verzweigeschaltung angeschlossen. Diese bewirkt, dass ein entgegengesetzter Stromfluss zwischen diesen beiden Hilfspinsammelleitungen auf wenigstens drei, insbesondere vier verschiedene Hilfsleitungen geführt wird. Mit anderen Worten wird ein Stromfluss zwischen den beiden Hilfspinsammelleitungen in der ersten Richtung zum Beispiel auf zwei bestimmte Hilfsleitungen geführt. Ein entgegengesetzter Stromfluss zwischen den beiden Hilfspinsammelleitungen (Durchströmung in der anderen Richtung) wird dagegen auf zwei andere Hilfsleitungen geführt. Somit erfolgt eine zwei-zu-vier Verzweigung in der Verzweigeschaltung. Der Effekt wird insbesondere durch eine selektive Stromleitung, zum Beispiel ein Diodennetzwerk realisiert. Die Hilfsmittel zur Stromverzweigung, z.B. das Diodennetzwerk, kann sowohl in der Verzweigeschaltung selbst, in der Testpunktkarte / Testpunktverdichterkarte, oder auch jenseits der Verzweigeschaltung zum Prüfmodul hin (im Prüfmodul oder auch in den Hilfsleitungen) erfolgen. Z.B. bewirken Leuchtioden in den Prüfmodulen die entsprechende Verzweigung. Auch die Verzweigeschaltung kann also im Hilfspinverdichter oder auch außerhalb des Hilfspinverdichters in Richtung zum Kabelbaum hin angeordnet sein. Die Verzweigeschaltung weist also insbesondere zwei unidirektionale Stromflusszweige entgegengesetzter Durchflussrichtung auf, die zwischen zwei Hilfspinsammelleitungen parallel geschaltet sind. Entsprechende Flusszweige sind also nur in einer Richtung durchströmbar, zum Beispiel durch die Einschaltung von antiparallelen Dioden in den entsprechenden Flusszweigen. Auch so lässt sich ein besonders einfacher und kostengünstiger Hilfspinverdichter realisieren.

Insbesondere in Bezug auf Leuchtdioden als Teil der Infrastruktur kann jedoch auch auf eine Verzweigeschaltung verzichtet werden. Die Leuchtdioden können dann über je einen der Hilfskontakte einseitig angeschlossen werden, wobei deren jeweilige andere Seite dann auf einer gemeinsamen Versorgungsleitung nach Masse oder zu einer Versorgungsspannung geführt wird.

In einer bevorzugten Ausführungsform wird am Hilfspinverdichter die eindeutige Kodierung der Hilfsleitungen wie folgt bewerkstelligt: Zwischen zwei der Hilfspinsammelleitungen ist (wiederum in Richtung zum Kabelbaum hin) eine Kodierschaltung angeschlossen. Die Kodierschaltung weist eine elektrische Kenngröße - insbesondere einen ohmschen Widerstand - auf. Diese Kenngröße ist über die Hilfspinsammelleitungen, z.B. durch eine Eingangsimpedanzmessung in die Kodierschaltung hinein, ermittelbar. Die Kenngröße ist anhand wenigstens dreier an der Kodierschaltung angeschlossenen Hilfsleitungen veränderbar. Auch hier ist eine entsprechende eindeutige Kodierung realisiert, d.h. durch die Bestimmung der elektrischen Kenngröße kann ermittelt werden, welche der Hilfsleitungen für die entsprechende Veränderung verantwortlich ist. Somit kann z.B. eine Ermittlung stattfinden, welche der Hilfsleitungen die Veränderung verursacht hat. So kann z.B.: ein Schalterzustand eines Schalters ermittelt werden, der zwischen den beiden Hilfsleitungen angeschlossen ist. Entsprechende Kodierschaltungen lassen sich besonders einfach realisieren.

In einer bevorzugten Variante dieser Ausführungsform enthält die Kodierschaltung eine Reihen- und / oder Parallelschaltung von Kennbauteilen, insbesondere Widerständen, verschiedener elektrischer Eigenschaften, insbesondere Widerstandswerten. Die Kennbauteile sind insbesondere hinsichtlich dieser Eigenschaften paarweise verschieden. Auch hier sind die Eigenschaften aus einem elektrischen Signal rekonstruierbar, welches in bzw. an den Hilfspinsammelleitungen messbar ist. Insbesondere sind hier Kennbauteile vorgesehen, welche paarweise nach einem Binärsystem oder Zehnerpotenzen usw. verteilte Werte aufweisen. So ist auch bei einer Kombination von verschiedenen Widerstandswerten stets eine eindeutige Zuordnung zu Einzelwerten möglich. Die elektrische Kenngröße ist dabei dadurch veränderbar, dass wenigstens zwei der Kennbauteile über wenigstens drei der Hilfsleitungen beschaltbar sind. Die Beschaltung kann eine Eigenschaft des Kennbauteils beeinflussen. Die jeweilige Beschaltung ist jedoch insbesondere ein Kurzschließen oder Überbrücken des jeweiligen Kennbauteils, so dass dessen Eigenschaften nicht verändert, jedoch der Kennwert beeinflusst wird. Insbesondere enthält die Kodierschaltung eine Reihenschaltung von Widerständen binär verteilter Widerstandswerte, wobei jeder der Widerstandswerte jeweils über eine Brücke zwischen zwei Hilfsleitungen überbrückbar, d.h. kurzschließbar ist. Auch eine derartige Schaltung lässt sich besonders einfach und kostengünstig aufbauen und elektrisch auswerten.

In einer bevorzugten Variante der Kombination der oben genannten Ausführungsformen ist die Verzweigeschaltung und die Kodierschaltung zwischen den selben beiden Hilfspinsammelleitungen angeschlossen. Mit anderen Worten erfolgt eine Parallelschaltung von Verzweigeschaltung und Kodierschaltung an zwei der Hilfspinsammelleitungen. Die oben genannten Eigenschaften von Verzweigeschaltung und Kodierschaltung lassen sich so zwischen zwei Hilfspinsammelleitungen kombinieren. Dies für führt zu einer besonders effektiven Verdichtung der Hilfsleitungen (Reduzierung der Hilfspinsammelanzahl gegenüber der Hilfspinanzahl).

Die Aufgabe der Erfindung wird auch gelöst durch einen Prüftisch gemäß Patentanspruch 16. Der Prüftisch ist ein solcher für einen Kabelbaum. Der Prüftisch ist dazu eingerichtet, dass auf diesem der Kabelbaum geprüft wird. Der Prüftisch enthält eine erfindungsgemäße Prüfanordnung, die dazu eingerichtet ist, den Kabelbaum auf dem Prüftisch zu prüfen. Der Begriff "Prüftisch" ist hier eher funktional zu verstehen und meint jedwede Anordnung, auf welcher der Kabelbaum einer Prüfung unterzogen werden kann.

Der Prüftisch und zumindest ein Teil dessen möglicher Ausführungsformen sowie die jeweiligen Vorteile wurden sinngemäß bereits im Zusammenhang mit der erfindungsgemäßen Prüfanordnung erläutert.

In einer bevorzugten Ausführungsform ist der Prüftisch ein Prüfmontagetisch. Der Prüfmontagetisch ist dazu eingerichtet, dass auf diesem der Kabelbaum geprüft und gefertigt werden kann. Auch der "Prüfmontagetisch" ist hierbei funktional eben in Abgrenzung zu einem reinen "Prüftisch" zu verstehen. Gemeint ist auch hier eine Anordnung, auf der sowohl die Montage / Fertigung als auch die Prüfung des Kabelbaums stattfinden kann. Insofern muss der Prüfmontagetisch nicht ein tatsächlich zur Montage ertüchtigter Prüftisch sein, sondern kann von diesem in verschiedensten Aspekten abweichen. Diese Fertigung erfolgt in der Regel durch Anordnen / Bündeln der Leitungen des Kabelbaumes und Versehen mit Steckern.

Der Prüfmontagetisch enthält die erfindungsgemäße Prüfanordnung. Diese ist dann dazu eingerichtet, den Kabelbaum wenigstens nach der Montage auf dem Prüfmontagetisch zu prüfen. Insbesondere erfolgt die Prüfung jedoch bereits während der Herstellung, insbesondere permanent oder sukzessive oder intervallweise, zum Beispiel nach der Montage einer jeweiligen Leitung oder der Komplettierung eines jeweiligen Steckers usw. So kann eine kostengünstige Kabelbaumprüfung insbesondere bereits während der Kabelbaum-Fertigung realisiert werden. Fehler, zum Beispiel die Verwendung einer defekten Leitung oder die Falschmontage einer Leitung (Verlegung zwischen falschen Steckern, falschen Steckerpins) im Kabelbaum können so sofort erkannt und korrigiert werden.

Weitere Merkmale, Wirkungen und Vorteile der Erfindung ergeben sich aus der nachfolgenden Beschreibung eines bevorzugten Ausführungsbeispiels der Erfindung sowie der beigefügten Figuren. Dabei zeigen, jeweils in einer schematischen Prinzipskizze:
- Figur 1: ein Prüfsystem mit Prüfanordnung auf einem Prüftisch für einen und mit einem Kabelbaum,
- Figur 2: eine der Prüfeinheiten aus Figur 1 mit aktiver Testpunktkarte,
- Figur 3: eine der Prüfeinheiten aus Figur 1 mit passiver Testpunktverdichterkarte und Sammeltestpunktkarte,
- Figur 4: den Steckerpinverdichter aus Figur 3,
- Figur 5: den Infrastrukturverdichter aus Figuren 2 und 3.

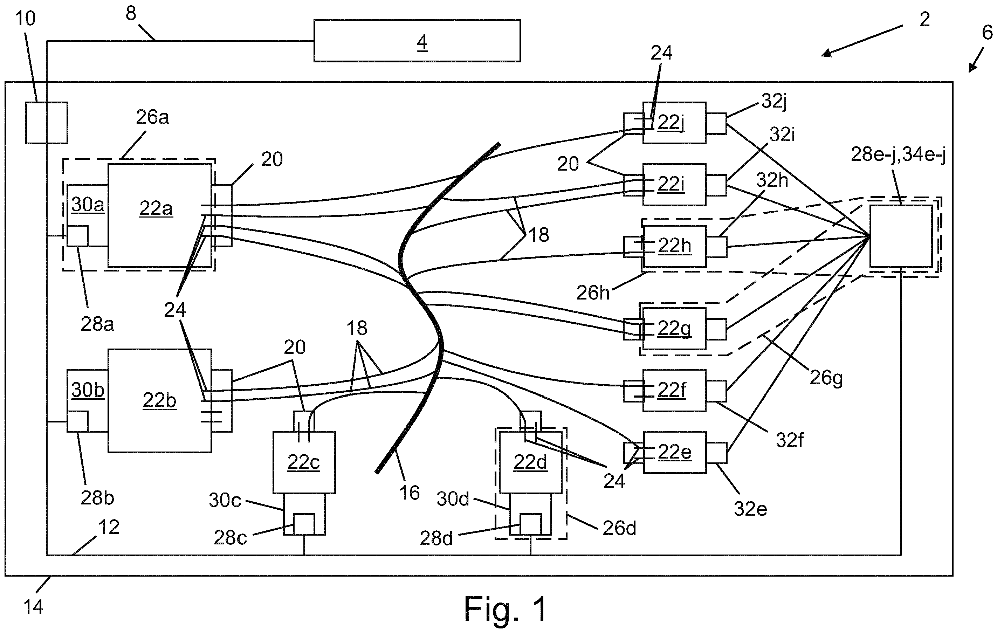

Figur 1 zeigt ein Prüfsystem 2. Dieses enthält eine Zentraleinheit 4 sowie eine an der Zentraleinheit 4 angeschlossene Prüfanordnung 6. Beide sind über eine Schnittstelle 10 der Prüfanordnung 6, hier eine Steuerungskarte, miteinander verbunden. Eine Datenleitung 8, hier einen Ethernet-Bus bzw. ein Ethernet-Kabel, führt von der Prüfanordnung 6 bzw. der Schnittstelle 10 zur Zentraleinheit.

Die Prüfanordnung 6 enthält eine an der Schnittstelle 10 angeschlossene Sammelleitung 12, hier einen CAN-Bus auf der Basis eines Ethernet-Kabels. Die Schnittstelle 10 / Steuerungskarte übernimmt die Protokollkonvertierung zwischen den beiden Bussen.

Die Prüfanordnung 6 ist hier auf einem Prüftisch 14, hier einem Prüfmontagetisch, für einen Kabelbaum 16 angeordnet. Der Kabelbaum 16 besteht aus einer Vielzahl von Leitungen 18, von welchen aus Gründen der Übersichtlichkeit hier nur ein Teil dargestellt ist. Die Leitungen sind zwischen Steckern 20 des Kabelbaumes 16 zu verlegen. Das Prüfsystem 2 ist dadurch in der Lage, den Kabelbaum 16 bereits während seiner Fertigung bzw. Entstehung auf dem Prüftisch 14 permanent zu prüfen. Fehler, zum Beispiel die Verwendung einer defekten Leitung 18 oder die Falschmontage einer Leitung 18 (Verlegung zwischen falschen Steckern 20) im Kabelbaum 16 können so sofort erkannt und korrigiert werden.

Das Prüfsystem 2 verfügt über eine Reihe von Prüfmodulen 22a-j, welche zur Aufnahme der Stecker 20 und damit zum Anschluss des Kabelbaumes 16 bzw. dessen Leitungen 18 dienen. Die Prüfmodule 22a,b sind vergleichsweise "groß", d.h. verfügen über hier jeweils 64 Steckerkontakte 24 zur Kontaktierung je einer jeweiligen einzigen Leitung 18 des Kabelbaumes 16 über die Stecker 20 (in der Figur nur für eine kleine Auswahl dargestellt).

Die restlichen Prüfmodule 20c-j sind vergleichsweise "kleine" Prüfmodule für kleinere Stecker mit je acht Steckerkontakten 24. Nicht alle Steckerkontakte 24 aller Prüfmodule 20a-j sind belegt, da der Kabelbaum 16 nicht über so viele Leitungen 18 verfügt.

Jedes der Prüfmodule 22a-j ist Teil einer Prüfeinheit 26a-j der Prüfanordnung 6. In der Figur sind der Übersichtlichkeit halber nur die Prüfeinheiten 26a,d,g,h jeweils durch gestrichelte Umrandungen gekennzeichnet. Jede der Prüfeinheiten 26a-j weist neben dem genau einen Prüfmodul 22a-j genau ein Anschlussmodul 28a-j auf.

Die beiden Prüfeinheiten 26a-d weisen jeweils genau eine aktive Testpunktkarte 30a-d auf. Das jeweilige Anschlussmodul 28a-d ist jeweils in der Testpunktkarte 30a-d enthalten bzw. in diese integriert ist. Die Prüfeinheiten 26e-j dagegen weisen je genau eine passive Testpunktverdichterkarte 32e-j und (in logischer Hinsicht) je genau eine Sammeltestpunktkarte 28e-j auf. Dabei weisen jedoch alle Prüfeinheiten 26e-j die selbe einzige aktive Sammeltestpunktkarte "28e-j" gemeinsam auf. Eigene Testpunktkarten "28f-j" existieren dinglich also nicht. Die Sammeltestpunktkarte(n) 34e-j bilden die bzw. sind die Anschlussmodule 28e-j der Prüfeinheiten 26e-j.

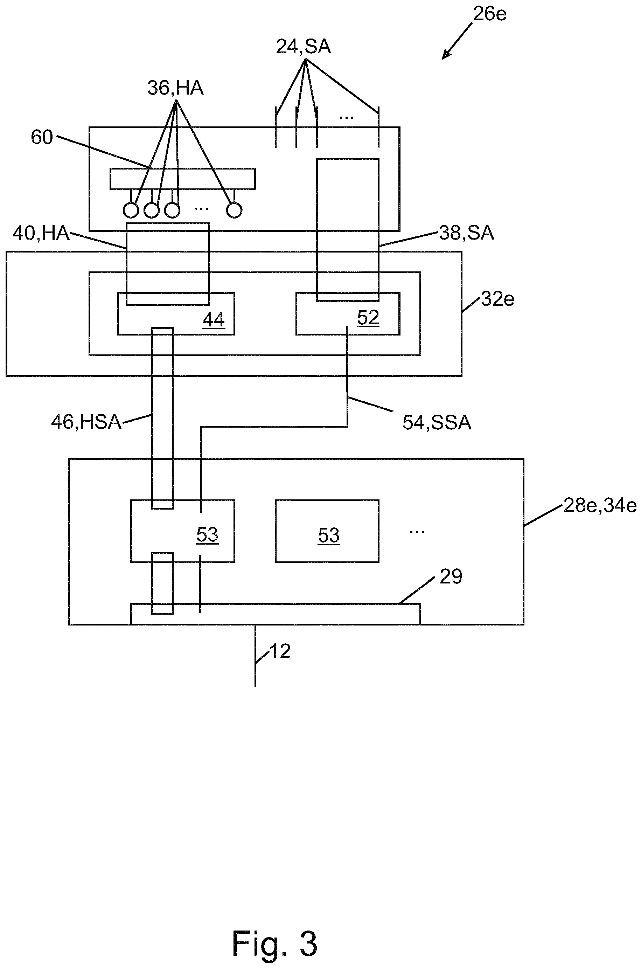

Vorliegend sind Ethernet-Kabel verwendet, um die Testpunktverdichterkarte 32e-j mit den (bzw. dem einzigen gemeinsamen) Anschlussmodul(en) 28e-j bzw. Sammeltestpunktkarte(n) 34e-j zu verbinden. Diese sind hier als einfache elektrische Verbindungsleitungen zweckentfremdet, ohne irgendwelche Busfunktionalität zu erfüllen. Hieraus ergibt sich der Vorteil, dass keine besonderen Kabel für die entsprechende Verbindung genutzt werden müssen. Aufgrund der Reduktion der Anzahl von nötigen Einzelleitungen (siehe unten zu Fig. 3, Anzahl ist nur noch HSA + SSA) reicht hier eine solches Standard-Ethernet-Kabel aus.

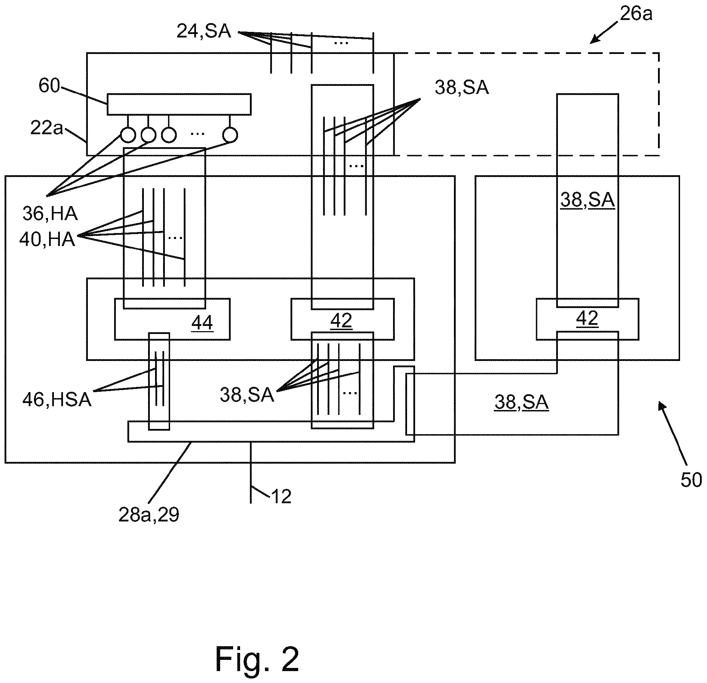

Figur 2 zeigt die Prüfeinheit 26a stellvertretend eine der Prüfeinheiten 26a-d.

Jedes der Prüfmodule 22a-j weist eine bestimmte Steckerpinanzahl SA von Steckerkontakten 24, hier Stecker-Pins auf; das Prüfmodul 22a hier SA=16. Jeder der Steckerkontakte 24 ist dabei jeweils signaltechnisch zum Anschlussmodul 28a-j zu führen. Das Anschlussmodul 28a-d weist hier jeweils einen Anschlussstecker 29, hier CAN-Bus-Stecker zum Anschluss an die Sammelleitung 12 auf.

Die Prüfmodule 22a-j weisen eine Hilfspinanzahl HA von Hilfskontakten 36 auf. Hier sind dies: Zwei mal ein Hilfskontakt 36 zum Anschluss einer jeweiligen LED (die andere Seite der LED ist auf eine Versorgungsspannung geführt), zwei Hilfskontakte 36 zum Anschluss eines Mikro-Hubmagneten, acht mal zwei Hilfskontakte 36 zum Anschluss eines jeweiligen Mikroschalters, also HA = 20. Auch jeder der Hilfskontakte 36 ist dabei jeweils signaltechnisch zum Anschlussmodul 28a-j zu führen. Die anzuschließenden Komponenten (LEDs, Hubmagnet, Mikroschalter, etc.) bilden eine Infrastruktur 60 des Prüfmoduls 22a-j.

In den Prüfeinheiten 26a-d sind alle SA Steckerkontakte 24 und alle HA Hilfskontakte 36 über eine jeweilige separate Steckerpinleitung 38 (Anzahl SA) und Hilfsleitung 40 (Anzahl HA) mit der aktiven Testpunktkarte 30a-d verbunden. In der Figur sind die einzelnen Leitungen nur angedeutet und durch Bänder verschiedener Breite symbolisiert. Die Veränderung der Breite der Bänder im Verlaufsweg elektrischer Signale soll eine Veränderung der Anzahl der darin enthaltenen Einzelleitungen verdeutlichen. Die Steckerpinanzahl SA der Steckerpinleitungen 38 ist hierbei (also als jeweilige einzelne Leitung) mit dem Anschlussmodul 28a-d verbunden. Es erfolgt noch eine Verarbeitung der elektrischen Signale auf den jeweiligen Steckerpinleitungen 38 in einer Verarbeitungseinheit 42.

Die Prüfmodule 22a-d enthalten je einen Hilfspinverdichter 44. Die Hilfspinanzahl HA von Hilfsleitungen 40 führt vom Prüfmodul 22a-d zum Hilfspinverdichter 44. Dort findet eine "Verdichtung" der HA Hilfsleitungen 40 statt, in dem nur weniger, hier nämlich nur eine Hilfspinsammelanzahl HSA=5 von Hilfspinsammelleitungen 46 vom Hilfspinverdichter 44 zum Anschlussmodul 28a-d führen. Der Verkabelungsaufwand in der aktiven Testpunktkarte 30a-d ist hierdurch reduziert und die Anzahl der notwendigen, über die Sammelleitung 12 anzusteuern Leitungen von SA + HA auf SA + HSA reduziert.

Ohne dies hier näher zu erläutern, ist die jeweilige aktive "Basis"-Testpunktkarte 30a-d durch Erweiterungseinheiten 50 um jeweils weitere SA=16 Steckerkontakte 24 bzw. Steckerpinleitungen 38 mit zugehöriger Verarbeitungseinheit 42 erweiterbar. Durch bis zu sieben Erweiterungseinheiten 50 können somit jeweils maximal 128 Steckerpins / Steckerkontakte 24 in Prüfmodulen 22a-d mit einer einzigen Prüfeinheit 26a-d versorgt werden.

Die Prüfeinheiten 26a-d enthalten keinen Steckerpinverdichter 52 (siehe unten).

Figur 3 zeigt den Aufbau der jeweiligen Prüfeinheiten 26e-j am Beispiel der Prüfeinheit 26e. Die Prüfeinheiten 26e-j enthalten jeweils einen Hilfspinverdichter 44 in der passiven Testpunktkarte 32e-j, für den sinngemäß die Ausführungen zu Figur 2 gelten. Allerdings sind hier kleinere Prüfmodule 22e-j vorhanden. Diese enthalten nur SA=12 Steckerkontakte 24 und HA=14 Hilfskontakte 36 (2 x 1 f. LED wie oben, 2 x 1 f. Mikro-Hubmotor wie oben, 5 x 2 f. Mikroschalter).

Die Steckerpinanzahl SA von Steckerpinleitungen 38 und die Hilfspinanzahl HA von Hilfsleitungen 40 ist vom Prüfmodul 22e-j bis zur Testpunktverdichterkarte 32e-j geführt. Dort wird die Verdichtung der Hilfsleitungen 40 entsprechend Figur 2 durchgeführt, indem diese mit Hilfe des Hilfspinverdichters 44 auf die Hilfspinsammelanzahl HSA = 5 von Hilfspinsammelleitungen 46 verdichtet werden.

Die Testpunktverdichterkarten 32e-j enthalten auch einen Steckerpinverdichter 52. Im Steckerpinverdichter 52 werden die Steckerpinanzahl SA von Steckerpinleitungen 38 auf die Steckerpinsammelanzahl SSA = 1 von hier nur einer Steckerpinsammelleitung 54 reduziert. Nur diese insgesamt HSA + SSA = 5 +1 sechs Leitungen führen von der Testpunktverdichterkarte 32e-j zur Sammeltestpunktkarte 34e-j in Form der Anschlussmodule 28e-j, welche schließlich über den Anschlussstecker 29 bzw. CAN-Bus-Stecker an dem CAN-Bus in Form der Sammelleitung 12 angeschlossen sind.

In der einzigen Sammeltestpunktekarte "34e-j" findet noch (für jede der 16 anschließbaren Testpunktkarten separat) eine Verarbeitung der verdichteten Signale auf den Hilfspinsammelleitungen 46 und den Steckerpinsammelleitungen 54 auf je einer von 16 Verarbeitungseinheiten 53 statt.

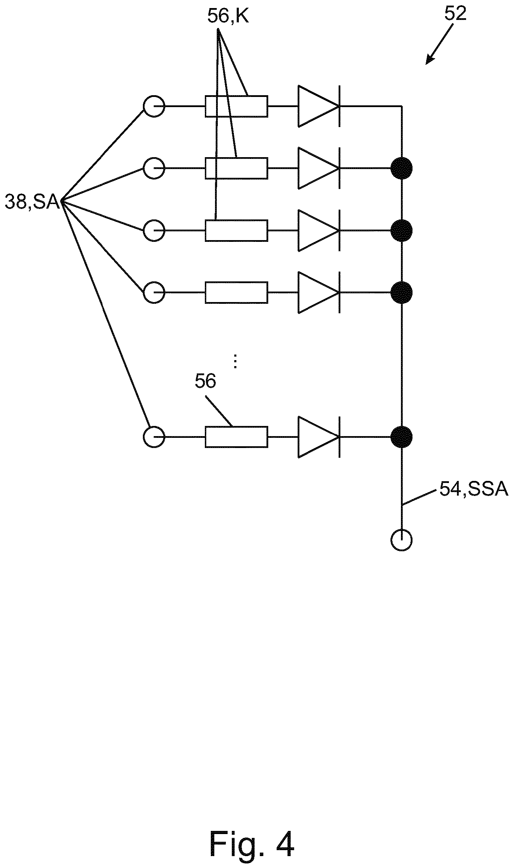

Figur 4 zeigt, wie die Verdichtung im Steckerpinverdichter 52 funktioniert: Die eindeutige Kodierung der SA Steckerpinleitungen 38 ist dadurch erreicht, dass jede dieser über je ein Kennbauteil 56 und eine nicht näher bezeichnete Diode auf eine hier einzige (SSA = 1) gemeinsame Steckerpinsammelleitung 54 geführt sind. Jedes der Kennbauteile 46 hat paarweise verschiedener elektrische Eigenschaften in Form einer Kenngröße K, hier einen verschiedenen ohmschen Widerstand. In der Reihenfolge von oben nach unten in Fig. 4: 100, 200, 300, ... bis 1200 Ohm bei SA=12 und 1600 Ohm bei SA=16. Ein jeweiliger Meßstrom der durch eine der Steckerpinleitungen 38 und schließlich über die Steckerpinsammelleitung 54 fließt, kann nun ausgewertet werden. Da seitens des Prüfsystems 2 sichergestellt ist, dass zu einem Zeitpunkt immer nur eine der Steckerpinleitungen 38 bestromt ist, kann anhand einer angemessenen Stromstärke die Kenngröße K ermittelt werden, also auf den jeweiligen ohmschen Widerstandswert und damit auf das betreffende Kennbauteil 56 und damit auf die betreffende Steckerpinleitung 38 eindeutig geschlossen werden.

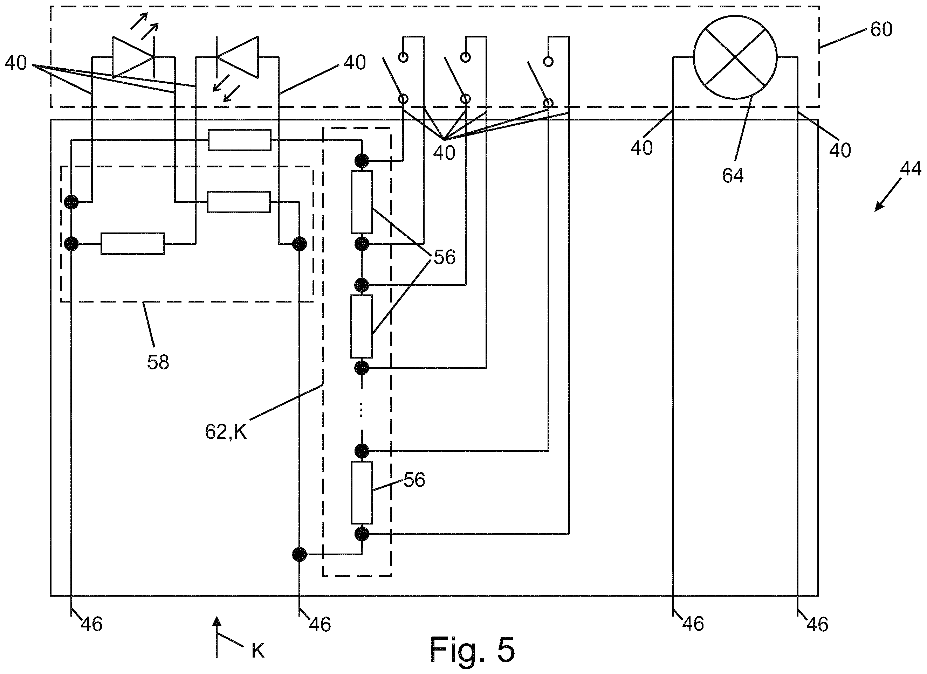

Figur 5 zeigt schließlich den Hilfspinverdichter 44. Hier ist an zwei der Hilfspinsammelleitungen 46 eine Verzweigeschaltung 58 angeschlossen, die insgesamt zu vier Hilfsleitungen 40 führt. Ein entgegengesetzter Stromfluss in den Hilfspinsammelleitungen 46 führt dazu, dass jeweils zwei der Hilfsleitungen 40 durchströmt werden. Dies ist dadurch erreicht, dass in der Infrastruktur 60 der Prüfmodule 22a-j unterschiedlich bzw. entgegengesetzt orientierte Leuchtdioden (mit nicht bezeichneten Vorwiderständen) an diesen vier Hilfsleitungen 40 angeschlossen sind. Durch unterschiedlich gerichteten Strom an den beiden Hilfspinsammelleitungen 46 können also zwei verschiedene Leuchtdioden als Teil der Infrastruktur 60 des Prüfmoduls 22 betrieben werden.

An den selben beiden Hilfspinsammelleitungen 46 ist parallel zu der Verzweigeschaltung 58 außerdem eine Kodierschaltung 62 (mit nicht bezeichnetem Vorwiderstand) angeschlossen. Diese weist eine elektrische Kenngröße K auf, hier einen ohmschen Reihenwiderstand. Der Reihenwiderstand ist durch eine Reihenschaltung von Kennbauteilen 56 erreicht. Diese weisen wieder unterschiedliche elektrischer Eigenschaften, hier ohmsche Widerstandswerte auf. Die Kenngröße K ist über die Hilfspinsammelleitungen 46 messbar (hier anhand einer Messung des Eingangswiderstandes, durch einen Pfeil angedeutet) und anhand weiterer, hier sechs, Hilfsleitungen 40 veränderbar. Dies ist dadurch bewerkstelligt, dass je zwei der Hilfsleitungen 40 zu drei Mikroschaltern der Infrastruktur 60 der Prüfmodule 22a-j führen. Durch jeweiliges Betätigen der Mikroschalter wird je eines der in Reihe geschalteten Kennbauteile 56 überbrückt bzw. kurzgeschlossen. Die elektrische Kenngröße K, hier der elektrische Summenwiderstand, ändert sich dadurch. Die Kennbauteile 56 sind hier wieder ohmsche Widerstände, deren Werte nach einem Binärsystem verteilt sind, hier in der Figur von oben nach unten: 5120, 2560, ... 320 Ohm für fünf Kennbauteile 56 bzw.

Mikroschalter (Prüfeinheiten 26e-j) oder bis 40 Ohm (acht Kennbauteile 56 / Mikroschalter, Prüfeinheiten 26a-d). Selbst beim Kurzschluss mehrerer Mikroschalter entsteht somit ein nach dem Binärsystem verteilter Kennwert K, der eindeutig zuordenbarer ist: Aus dem Kennwert K ist eindeutig erkennbar, welche der Kennbauteile 56 gerade überbrückt sind und welche nicht.

Schließlich sind noch zwei der Hilfspinsammelleitungen 46 auf den oben erläuterten Mikro-Hubmagneten 64 der Infrastruktur 60 geführt, der dazu dient, bei Bestromung einen jeweiligen Stecker 20 aus einem jeweiligen Prüfmodul 22 elektrisch auszuwerfen. Mit dem Mikro-Hubmagneten 64 wird also die ober erläuterte elektrisch lösbare, hier elektromagnetische Haltevorrichtung realisiert.

In Figur 1 sind gemäß einem hier nicht näher erläuterten Optimierungsverfahren die Prüfmodule 22a-j so gewählt und jeweiligen Prüfeinheiten 26a-j so zugeordnet, dass die Anzahl aufwendiger und teurer Prüfeinheiten 26a-d mit aktiven Testpunktkarten 30 und ohne Steckerpinverdichter 52 minimiert ist und möglichst viele einfache kostengünstige und passive Prüfeinheiten 26e-j genutzt werden. Die Komplexität steckt dabei alleine in der Ansteuerung und Versorgung des Kabelbaumes 16 mit Prüfsignalen ausschließlich über die Prüfeinheiten 26a-d. Dank der Prüfeinheiten 26e-j können die durch den Kabelbaum 16 geleiteten Signale kostengünstig und einfach empfangen und ausgewertet werden.

### Bezugszeichenliste

- 2: Prüfsystem
- 4: Zentraleinheit
- 6: Prüfanordnung
- 8: Datenleitung
- 10: Schnittstelle
- 12: Sammelleitung
- 14: Prüftisch
- 16: Kabelbaum
- 18: Leitung (Kabelbaum)
- 20: Stecker (Kabelbaum)
- 22a-j: Prüfmodul
- 24: Steckerkontakt
- 26a-j: Prüfeinheit
- 28a-j: Anschlussmodul
- 29: Anschlussstecker
- 30a-d: Testpunktkarte (aktiv)
- 32e-j: Testpunktverdichterkarte (passiv)
- 34e-j: Sammeltestpunktkarte (aktiv)
- 36: Hilfskontakt
- 38: Steckerpinleitung
- 40: Hilfsleitung
- 42: Verarbeitungseinheit (Steckerpinleitung)
- 44: Hilfspinverdichter
- 46: Hilfspinsammelleitung
- 50: Erweiterungseinheit
- 52: Steckerpinverdichter
- 53: Verarbeitungseinheit (Stecker- / Hilfspinsammelleitung)
- 54: Steckerpinsammelleitung
- 56: Kennbauteil
- 58: Verzweigeschaltung
- 60: Infrastruktur
- 62: Kodierschaltung
- 64: Hubmagnet

- SA: Steckerpinanzahl
- SSA: Steckerpinsammelanzahl
- HA: Hilfspinanzahl
- HSA: Hilfspinsammelanzahl
- K: Kenngröße

## Patentansprüche

1. Prüfanordnung (6) für ein Prüfsystem (2) zum Prüfen eines Kabelbaumes (16),
- mit einer Sammelleitung (12), die an einer Zentraleinheit (4) des Prüfsystems (2) anschließbar ist,
- mit einer Mehrzahl von Prüfeinheiten (26a-j), wobei jede der Prüfeinheiten (26a-j) genau ein an der Sammelleitung (12) angeschlossenes Anschlussmodul (28a-j) und genau ein an diesem angeschlossenes Prüfmodul (22a-j) aufweist,
- wobei jedes der Prüfmodule (22a-j) aufweist:
- eine Steckerpinanzahl (SA) von jeweils einpoligen elektrischen Steckerkontakten (24) für den Kabelbaum (16), und
- eine Hilfspinanzahl (HA) von elektrischen Hilfskontakten (36) für eine Infrastruktur (60) des Prüfmoduls (22a-j),
- wobei wenigstens eine der Prüfeinheiten (26a-j) einen Steckerpinverdichter (52) und / oder einen Hilfspinverdichter (44) enthält,
- wobei im Fall des Steckerpinverdichters (52) die Steckerkontakte (24) über die Steckerpinanzahl (SA) von Steckerpinleitungen (38) zum Steckerpinverdichter (52) geführt sind und eine kleinere Steckerpinsammelanzahl (SSA) von Steckerpinsammelleitungen (54) vom Steckerpinverdichter (52) zum Anschlussmodul (28a-j) geführt ist, wobei der Steckerpinverdichter (52) so eingerichtet ist, dass in diesem wenigstens zwei der Steckerpinleitungen (38) eindeutig kodiert auf eine der Steckerpinsammelleitungen (54) geführt sind,
- wobei im Fall des Hilfspinverdichters (44) die Hilfskontakte (36) über die Hilfspinanzahl (HA) von Hilfsleitungen (40) zum Hilfspinverdichter (44) geführt sind und eine kleinere Hilfspinsammelanzahl (HSA) von Hilfspinsammelleitungen (46) vom Hilfspinverdichter (44) zum Anschlussmodul (28a-j) geführt ist, wobei der Hilfspinverdichter (44) so eingerichtet ist, dass in diesem wenigstens zwei der Hilfsleitungen (40) eindeutig kodiert auf eine der Hilfspinsammelleitungen (54) geführt sind,
- wobei ansonsten in den Prüfeinheiten (26a-j) die Steckerpinanzahl (SA) von Steckerpinleitungen (38) und/oder die Hilfspinanzahl (HA) von Hilfsleitungen (40) vom jeweiligen Prüfmodul (22a-j) zum jeweiligen Anschlussmodul (28a-j) geführt ist.

2. Prüfanordnung (6) nach Anspruch 1,
**dadurch gekennzeichnet, dass**
- wenigstens eine der Prüfeinheiten (26a-d) genau eine aktive Testpunktkarte (30a-d) enthält, die das Anschlussmodul (28a-d) enthält.

3. Prüfanordnung nach Anspruch 2,
**dadurch gekennzeichnet, dass**
- in der wenigstens einen der Prüfeinheiten (26a-d) die Steckerpinanzahl (SA) von Steckerpinleitungen (38) vom Prüfmodul (22a-d) zum Anschlussmodul (28a-d) geführt ist, und
- diese Prüfeinheiten (26a-d) keinen Steckerpinverdichter (52) enthalten.

4. Prüfanordnung (6) nach Anspruch 2 oder 3,
**dadurch gekennzeichnet, dass**
- die Prüfeinheit (26a-d) einen der Hilfspinverdichter (44) enthält.

5. Prüfanordnung (6) nach einem der vorhergehenden Ansprüche,
**dadurch gekennzeichnet, dass**
wenigstens eine der Prüfeinheiten (26e-j) genau eine passive Testpunktverdichterkarte (32e-j) und genau eine aktive Sammeltestpunktkarte (34e-j) enthält, wobei die Sammeltestpunktkarte (34e-j) das Anschlussmodul (28e-j) enthält oder ist,
- wobei die Steckerpinanzahl (SA) von Steckerpinleitungen (38) und die Hilfspinanzahl (HA) von Hilfsleitungen (40) vom Prüfmodul (22e-j) zur passiven Testpunktverdichterkarte (32e-j) geführt ist.

6. Prüfanordnung (6) nach Anspruch 5,
**dadurch gekennzeichnet, dass**
die Prüfeinheit (26e-j) einen der Hilfspinverdichter (44) und/oder einen der Steckerpinverdichter (52) enthält.

7. Prüfanordnung (6) nach einem der Ansprüche 5 bis 6,
**dadurch gekennzeichnet, dass**
wenigstens zwei der Prüfeinheiten (26e-j) die selbe Sammeltestpunktkarte (34e-j) gemeinsam aufweisen.

8. Prüfanordnung (6) nach einem der Ansprüche 5 bis 7,
**dadurch gekennzeichnet, dass**
wenigstens eine der passiven Testpunktverdichterkarten (32e-j) nicht zur Beschaltung der Steckerkontakte (24) nach einem Prüfschema des Prüfsystems (2) eingerichtet ist.

9. Prüfanordnung (6) nach einem der Ansprüche 2 bis 4 in Verbindung mit einem der Ansprüche 5 bis 8,
**dadurch gekennzeichnet, dass**
nach einem Optimierungsverfahren die Anzahl der Prüfeinheiten (26a-d) mit aktiven Testpunktkarten (30a-d) für die Prüfung eines bestimmten und vorgebbaren Kabelbaums (16) minimiert ist.

10. Prüfanordnung (6) nach einem der vorhergehenden Ansprüche,
**dadurch gekennzeichnet, dass**
die Sammelleitung (12) als ein Datenbus ausgeführt ist und wenigstens eine der Prüfeinheiten (26a-j) auf der der Sammelleitung (12) abgewandten Seite des Anschlussmoduls (28a-j) ohne Datenbus ausgeführt ist.

11. Prüfanordnung (6) nach einem der vorhergehenden Ansprüche,
**dadurch gekennzeichnet, dass**
am Steckerpinverdichter (52) die eindeutige Kodierung der Steckerpinleitungen (38) dadurch bewerkstelligt ist, dass wenigstens zwei der Steckerpinleitungen (38) über je ein Kennbauteil (56) paarweise verschiedener elektrischer Kenngrößen (K) auf eine gemeinsame Steckerpinsammelleitung (54) geführt sind.

12. Prüfanordnung (6) nach einem der vorhergehenden Ansprüche,
**dadurch gekennzeichnet, dass**
am Hilfspinverdichter (44) die eindeutige Kodierung der Hilfsleitungen (40) dadurch bewerkstelligt ist, dass zwischen zwei der Hilfspinsammelleitungen (46) eine Verzweigeschaltung (58) angeschlossen ist, durch die ein entgegengesetzter Stromfluss zwischen den beiden Hilfspinsammelleitungen (46) auf wenigstens drei verschiedene Hilfsleitungen (40) geführt ist.

13. Prüfanordnung (6) nach einem der vorhergehenden Ansprüche,
**dadurch gekennzeichnet, dass**
am Hilfspinverdichter (44) die eindeutige Kodierung der Hilfsleitungen (40) dadurch bewerkstelligt ist, dass zwischen zwei der Hilfspinsammelleitungen (46) eine Kodierschaltung (62) angeschlossen ist, die eine elektrische Kenngröße (K) aufweist, die anhand wenigstens dreier der Hilfsleitungen (40) veränderbar ist.

14. Prüfanordnung (6) nach Anspruch 13,
**dadurch gekennzeichnet, dass**
die Kodierschaltung (62) eine Reihen- und/oder Parallelschaltung von Kennbauteilen (56) verschiedener elektrischer Eigenschaften enthält, wobei die elektrische Kenngröße (K) dadurch veränderbar ist, dass wenigstens zwei der Kennbauteile (56) über wenigstens drei der Hilfsleitungen (40) beschaltbar sind.

15. Prüfanordnung (6) nach Anspruch 12 in Verbindung mit einem der Ansprüche 13 bis 14,
**dadurch gekennzeichnet, dass**
die Verzweigeschaltung (58) und die Kodierschaltung (62) zwischen den selben beiden Hilfspinsammelleitungen (46) angeschlossen sind.

16. Prüftisch (14) für einen Kabelbaum (16),
- wobei der Prüftisch (14) dazu eingerichtet ist, dass auf diesem der Kabelbaum (16) geprüft wird,
- mit einer Prüfanordnung (6) nach einem der vorhergehenden Ansprüche, die dazu eingerichtet ist, den Kabelbaum (16) auf dem Prüftisch (14) zu prüfen.

17. Prüftisch (14) nach Anspruch 16,
**dadurch gekennzeichnet, dass**
der Prüftisch (14) ein Prüfmontagetisch ist, der dazu eingerichtet ist, dass auf diesem der Kabelbaum (16) gefertigt und geprüft werden kann.

## Claims

1. A test set-up (6) for a test system (2) for testing a cable harness (16),
- with a collective line (12) which can be connected to a central unit (4) of the test system (2),
- with a plurality of test units (26a-j), wherein each of the test units (26a-j) has exactly one connection module (28a-j) connected to the collective line (12) and exactly one test module (22a-j) connected to said connection module,
- wherein each of the test modules (22a-j) has:
- a connector pin number (SA) of respective single-pole electrical connector contacts (24) for the cable harness (16), and
- an auxiliary pin number (HA) of electrical auxiliary contacts (36) for an infrastructure (60) of the test module (22a-j),
- wherein at least one of the test units (26a-j) comprises a connector pin consolidator (52) and/or an auxiliary pin consolidator (44),
- wherein, in the case of the connector pin consolidator (52), the connector contacts (24) are routed via the connector pin number (SA) of connector pin lines (38) to the connector pin consolidator (52), and a smaller connector pin collective number (SSA) of connector pin collective lines (54) is routed from the connector pin consolidator (52) to the connection module (28a-j), wherein the connector pin consolidator (52) is arranged such that in said connector pin consolidator (52) at least two of the connector pin lines (38) are routed in a uniquely coded manner to one of the connector pin collective lines (54),
- wherein, in the case of the auxiliary pin consolidator (44), the auxiliary contacts (36) are routed via the auxiliary pin number (HA) of auxiliary lines (40) to the auxiliary pin consolidator (44), and a smaller auxiliary pin collective number (HSA) of auxiliary pin collective lines (46) is routed from the auxiliary pin consolidator (44) to the connection module (28a-j), wherein the auxiliary pin consolidator (44) is arranged such that in said connector pin consolidator (52) at least two of the auxiliary lines (40) are routed in a uniquely coded manner to one of the auxiliary pin collective lines (54),
- wherein, otherwise, in the test units (26a-j), the connector pin number (SA) of connector pin lines (38) and/or the auxiliar pin number (HA) of auxiliary lines (40) is routed from the particular test module (22a-j) to the particular connection module (28a-j).

2. The test set-up (6) according to Claim 1,
**characterised in that**
- at least one of the test units (26a-d) comprises exactly one active test point card (30a-d), which comprises the connection module (28a-d).

3. The test set-up according to Claim 2,
**characterised in that**
- in at least one of the test units (26a-d), the connector pin number (SA) of connector pin lines (38) is routed from the test module (22a-d) to the connection module (28a-d), and
- said test units (26a-d) do not comprise a connector pin consolidator (52).

4. The test set-up (6) according to Claim 2 or 3,
**characterised in that**
- the test unit (26a-d) comprises one of the auxiliary pin consolidators (44).

5. The test set-up (6) according to any one of the preceding claims,
**characterised in that**
at least one of the test units (26e-j) comprise exactly one passive test point consolidator card (32e-j) and exactly one active collective test point card (34e-j), wherein the collective test point card (34e-j) comprises or is the connection module (28e-j),
- wherein the connector pin number (SA) of connector pin lines (38) and the auxiliar pin number (HA) of auxiliary lines (40) are routed from the test module (22e-j) to the passive test point consolidator card (32e-j).

6. The test set-up (6) according to Claim 5,
**characterised in that**
the test unit (26e-j) comprises one of the auxiliary pin consolidators (44) and/or one of the connector pin consolidators (52).

7. The test set-up (6) according to any one of Claims 5 to 6,
**characterised in that**
at least two of the test units (26e-j) have the same collective test point card (34e-j) in common.

8. The test set-up (6) according to any one of Claims 5 to 7,
**characterised in that**
at least one of the passive test point consolidator cards (32e-j) is not arranged for connection of the connector contacts (24) in accordance with a test scheme of the test system (2).

9. The test set-up (6) according to any one of Claims 2 to 4 in conjunction with any one of Claims 5 to 8,
**characterised in that**
according to an optimisation method, the number of test units (26a-d) with active test point cards (30a-d) for testing a specific and predeterminable cable harness (16) is minimised.

10. The test set-up (6) according to any one of the preceding claims,
**characterised in that**
the collective line (12) is designed as a data bus, and at least one of the test units (26a-j), on the side of the connection module (28a-j) facing away from the collective line (12), is designed without a data bus.

11. The test set-up (6) according to any one of the preceding claims, **characterised in that** in the connector pin consolidator (52), the unique coding of the connector pin lines (38) is achieved by at least two of the connector pin lines (38) being routed to a shared connector pin collective line (54) via respective characteristic components (56) that are of different electrical characteristics (K) in pairs.

12. The test set-up (6) according to any one of the preceding claims,
**characterised in that**
in the auxiliary pin consolidator (44), the unique coding of the auxiliary lines (40) is achieved by a branching circuit (58) being connected between two of the auxiliary pin collective lines (46), through which branching circuit an opposite current flow between the two auxiliary pin collective lines (46) is guided to at least three different auxiliary lines (40).

13. The test set-up (6) according to any one of the preceding claims,
**characterised in that**
in the auxiliary pin consolidator (44), the unique coding of the auxiliary lines (40) is achieved by a coding circuit (62) being connected between two of the auxiliary pin collective lines (46), which coding circuit (62) has an electrical characteristic (K) that can be changed by means of at least three of the auxiliary lines (40).

14. The test set-up (6) according to Claim 13,
**characterised in that**
the coding circuit (62) comprises a series and/or parallel connection of characteristic components (56) of different electrical properties, wherein it is possible to change the electrical characteristic (K) by at least two of the characteristic components (56) being able to be connected via at least three of the auxiliary lines (40).

15. The test set-up (6) according to Claim 12 in conjunction with any one of Claims 13 to 14,
**characterised in that**
the branching circuit (58) and the coding circuit (62) are connected between the same two auxiliary pin collective lines (46).

16. A test table (14) for a cable harness (16),
- wherein the test table (14) is arranged such that the cable harness (16) is tested thereon,
- with a test set-up (6) according to any one of the preceding claims, which is arranged to test the cable harness (16) on the test table (14).

17. The test table (14) according to Claim 16,
**characterised in that**
the test table (14) is a test assembly table, which is arranged such that the cable harness (16) can be manufactured and tested thereon.

## Revendications

1. Agencement de test (6) pour un système de test (2) pour tester un faisceau de câbles (16),
- avec une ligne collectrice (12), laquelle peut être connectée à une unité centrale (4) du système de test (2),
- avec une multiplicité d'unités de test (26a-j), chacune des unités de test (26a-j) présentant exactement un module de raccordement (28a-j) raccordé à la ligne collectrice (12) et exactement un module de test (22a-j) raccordé à celui-ci,
- chacun des modules de test (22a-j) présentant :
- un nombre de broches de connecteurs (SA) de contacts de connecteurs (24) électriques respectivement unipolaires pour le faisceau de câbles (16), et
- un nombre de broches auxiliaires (HA) de contacts auxiliaires (36) électriques pour une infrastructure (60) du module de test (22a-j),
- au moins l'une des unités de test (26a-j) comprenant un réducteur de broches de connecteurs (52) et/ou un réducteur de broches auxiliaires (44),
- dans le cas du réducteur de broches de connecteurs (52), les contacts de connecteurs (24) étant amenés, par le nombre de broches de connecteurs (SA), des lignes de broches de connecteurs (38) au réducteur de broches de connecteurs (52) et un plus petit nombre collecteur de broches de connecteurs (SSA) des lignes collectrices de broches de connecteurs (54) étant amené du réducteur de broches de connecteurs (52) au module de raccordement (28a-j), le réducteur de broches de connecteurs (52) étant agencé de telle sorte que dans celui-ci au moins deux des lignes de broches de connecteurs (38), codées de façon claire, sont amenées à l'une des lignes collectrices de broches de connecteurs (54),
- dans le cas du réducteur de broches auxiliaires (44), les contacts auxiliaires (36) étant amenés par le nombre de broches auxiliaires (HA) de lignes auxiliaires (40) au réducteur de broches auxiliaires (44) et un plus petit nombre collecteur de broches auxiliaires (HSA) de lignes collectrices de broches auxiliaires (46) étant amené du réducteur de broches auxiliaires (44) au module de raccordement (28a-j), le réducteur de broches auxiliaires (44) étant agencé de telle sorte que dans celui-ci au moins deux des lignes auxiliaires (40), codées de façon claire, sont amenées à l'une des lignes collectrices de broches auxiliaires (54),
- par ailleurs, le nombre de broches de connecteurs (SA) de lignes de broches de connecteurs (38) et/ou le nombre de broches auxiliaires (HA) de lignes auxiliaires (40) étant amenés du module de test (22a-j) respectif au module de raccordement (28a-j) respectif.

2. Agencement de test (6) selon la revendication 1,
**caractérisé en ce qu'**
- au moins l'une des unités de test (26a-d) comprend exactement une carte de points de test (30a-d) active, laquelle comprend le module de raccordement (28a-d).

3. Agencement de test selon la revendication 2,
**caractérisé en ce que**,
- dans l'au moins une des unités de test (26a-d), le nombre de broches de connecteurs (SA) de lignes de broches de connecteurs (38) est amené du module de test (22a-d) au module de raccordement (28a-d), et
- ces unités de test (26a-d) ne comprennent aucun réducteur de broches de connecteurs (52).

4. Agencement de test (6) selon la revendication 2 ou 3,
**caractérisé en ce que**
- l'unité de test (26a-d) comprend l'un des réducteurs de broches auxiliaires (44).

5. Agencement de test (6) selon l'une quelconque des revendications précédentes,
**caractérisé en ce qu'**
au moins une des unités de test (26e-j) comprend exactement une carte de réducteur de points de test (32e-j) passive et exactement une carte de points de test collectrice (34e-j) active, la carte de points de test collectrice (34e-j) comprenant ou étant le module de raccordement (28e-j),
- le nombre de broches de connecteurs (SA) de lignes de broches de connecteurs (38) et le nombre de broches auxiliaires (HA) de lignes auxiliaires (40) étant amenés du module de test (22e-j) à la carte de réducteur de points de test (32e-j) passive.

6. Agencement de test (6) selon la revendication 5,
**caractérisé en ce que**
l'unité de test (26e-j) comprend l'un des réducteurs de broches auxiliaires (44) et/ou l'un des réducteurs de broches de connecteurs (52).

7. Agencement de test (6) selon l'une quelconque des revendications 5 à 6,
**caractérisé en ce qu'**
au moins deux des unités de test (26e-j) présentent en commun la même carte de points de test collectrice (34e-j).

8. Agencement de test (6) selon l'une quelconque des revendications 5 à 6,
**caractérisé en ce qu'**
au moins l'une des cartes de réducteur de points de test (32e-j) passives n'est pas agencée pour la connexion des contacts de connecteurs (24) selon un schéma de test du système de test (2).

9. Agencement de test (6) selon l'une quelconque des revendications 2 à 4 en association avec l'une des revendications 5 à 8,
**caractérisé en ce que**
le nombre des unités de test (26a-d) avec cartes de points de test (30a-d) actives est réduit selon un procédé d'optimisation, pour le test d'un faisceau de câbles (16) déterminé et spécifiable.

10. Agencement de test (6) selon l'une quelconque des revendications précédentes,
**caractérisé en ce que**
la ligne collectrice (12) est réalisée comme un bus de données et **en ce qu'**au moins l'une des unités de test (26a-j) du côté du module de raccordement (28a-j) opposé à la ligne collectrice (12) est réalisée sans bus de données.

11. Agencement de test (6) selon l'une quelconque des revendications précédentes,
**caractérisé en ce que**,
sur le réducteur de broches de connecteurs (52), le codage clair des lignes de broches de connecteurs (38) est réalisé par le fait qu'au moins deux des lignes de broches de connecteurs (38) sont amenées à une ligne collectrice de broches de connecteurs (54) commune par respectivement un composant caractéristique (56) de grandeurs caractéristiques électriques (K) différentes par paires.

12. Agencement de test (6) selon l'une quelconque des revendications précédentes,
**caractérisé en ce que**,
sur le réducteur de broches auxiliaires (44), le codage clair des lignes auxiliaires (40) est réalisé par le fait que, entre deux des lignes collectrices de broches auxiliaires (46), un circuit de répartition (58) est raccordé, par lequel un courant opposé entre les deux lignes collectrices de broches auxiliaires (46) est amené à au moins trois lignes auxiliaires (40) différentes.

13. Agencement de test (6) selon l'une quelconque des revendications précédentes,
**caractérisé en ce que**,
sur le réducteur de broches auxiliaires (44), le codage clair des lignes auxiliaires (40) est réalisé par le fait que, entre deux des lignes collectrices de broches auxiliaires (46), un circuit de codage (62) est raccordé, lequel présente une grandeur caractéristique électrique (K) qui est modifiable à l'aide d'au moins trois des lignes auxiliaires (40).

14. Agencement de test (6) selon la revendication 13,
**caractérisé en ce que**
le circuit de codage (62) comprend un montage en série et/ou en parallèle de composants caractéristiques (56) de propriétés électriques différentes, la grandeur caractéristique électrique (K) étant modifiable par le fait qu'au moins deux des composants caractéristiques (56) peuvent être connectés par au moins trois des lignes auxiliaires (40).

15. Agencement de test (6) selon la revendication 12 en association avec l'une quelconque des revendications 13 à 14,
**caractérisé en ce que**
le circuit de répartition (58) et le circuit de codage (62) sont raccordés entre les mêmes deux lignes collectrices de broches auxiliaires (46).

16. Table d'essai (14) pour un faisceau de câbles (16),
- la table d'essai (14) étant agencée afin que le faisceau de câbles (16) soit testé sur celle-ci,
- avec un agencement de test (6) selon l'une quelconque des revendications précédentes, lequel est agencé pour tester le faisceau de câbles (16) sur la table d'essai (14).

17. Table d'essai (14) selon la revendication (16),
**caractérisée en ce que**
la table d'essai (14) est une table de montage de test, laquelle est agencée pour pouvoir fabriquer et tester le faisceau de câbles (16) sur celle-ci.
